Europäisches Patentamt

European Patent Office

Office européen des brevets

(11) Numéro de publication: **0 142 440**
**A2**

## (12) DEMANDE DE BREVET EUROPEEN

(21) Numéro de dépôt: **84402267.3**

(22) Date de dépôt: **09.11.84**

(51) Int. Cl.⁴: **H 03 K 5/00**
**H 03 L 7/24**

(30) Priorité: **15.11.83 FR 8318134**

(43) Date de publication de la demande:
**22.05.85 Bulletin 85/21**

(84) Etats contractants désignés:
**DE FR GB IT NL SE**

(71) Demandeur: **THOMSON-CSF**
**173, Boulevard Haussmann**
**F-75379 Paris Cedex 08(FR)**

(72) Inventeur: **Brault, Roland**
**THOMSON-CSF SCPI 173, bld Haussmann**
**F-75379 Paris Cedex 08(FR)**

(74) Mandataire: **Ruellan-Lemonnier, Brigitte et al,**
**THOMSON-CSF SCPI 173, boulevard Haussmann**
**F-75379 Paris Cedex 08(FR)**

(54) Dispositif de génération d'une fréquence fractionnaire d'une fréquence de référence.

(57) La présente invention concerne un dispositif de génération d'une fréquence fractionnaire d'une fréquence de référence.

Ce dispositif comporte essentiellement un générateur
(11) de fréquence de référence délivrant en sortie un signal
de référence de fréquence f, un diviseur de fréquence (12)
par un nombre entier p délivrant en sortie un signal à une
fréquence f/p et un moyen numérique (14) d'extraction de la
fréquence harmonique de rang n délivrant un signal à une
fréquence multiple de manière à obtenir en sortie du
dispositif un signal de type numérique de fréquence n/pf.

Ce dispositif est utilisé dans les systèmes numériques
pour générer des signaux d'horloge à des fréquences
différentes.

$\mathsf{FIG\_3}$

```
┌─────────────┐
│ GENERATEUR DE│ ⌐11
│  FREQUENCE   │
└─────────────┘
       │ f
       ▼
┌─────────────┐
│  DIVISEUR    │ ⌐12
│  PAR   p     │
└─────────────┘
       │ f/p
       ▼
┌─────────────┐
│ MODIFICATION DU│ ⌐13
│   FACTEUR    │
│  DE FORME    │
└─────────────┘
       │ f/p
       ▼
┌─────────────┐
│ EXTRACTION DE│ ⌐14
│ L'HARMONIQUE │
│ DE RANG  n   │
└─────────────┘
       │ n/p f
       ▼
┌─────────────┐
│    MISE      │ ⌐15
│  EN FORME    │
└─────────────┘
       │
       ▼
   F = n/p f
```

EP 0 142 440 A2

0142440

### DISPOSITIF DE GENERATION D'UNE FREQUENCE FRACTIONNAIRE D'UNE FREQUENCE DE REFERENCE

La présente invention concerne un dispositif de génération d'une fréquence fractionnaire d'une fréquence de référence, à savoir un dispositif générant une fréquence $\frac{n}{p}$ f à partir d'une fréquence f dans laquelle n et p sont des nombres entiers.

De tels dispositifs sont en particulier utilisés dans les systèmes électroniques numériques. En effet, ces systèmes nécessitent généralement un ensemble de signaux d'horloge et de synchronisation présentant des relations de fréquences et de phases déterminées. Or les fréquences des signaux d'horloge à générer ne sont pas toujours des multiples ou des sous-multiples entiers du signal d'horloge de référence. Toutefois, dans la majorité des cas, les fréquences des signaux d'horloge à générer sont des fractions de la fréquence d'horloge de référence et elles sont données par l'équation suivante :

$$F = \frac{n}{p} f$$

dans laquelle f est la fréquence d'horloge de référence et n et p sont des nombres entiers supérieurs ou égaux à 1.

Il existe actuellement diverses solutions pour obtenir, à partir d'une fréquence f, une fréquence $F = \frac{n}{p} f$.

Parmi ces solutions, les plus utilisées sont la boucle à verrouillage de phase et l'utilisation de la fréquence PPCM (plus petit commun multiple).

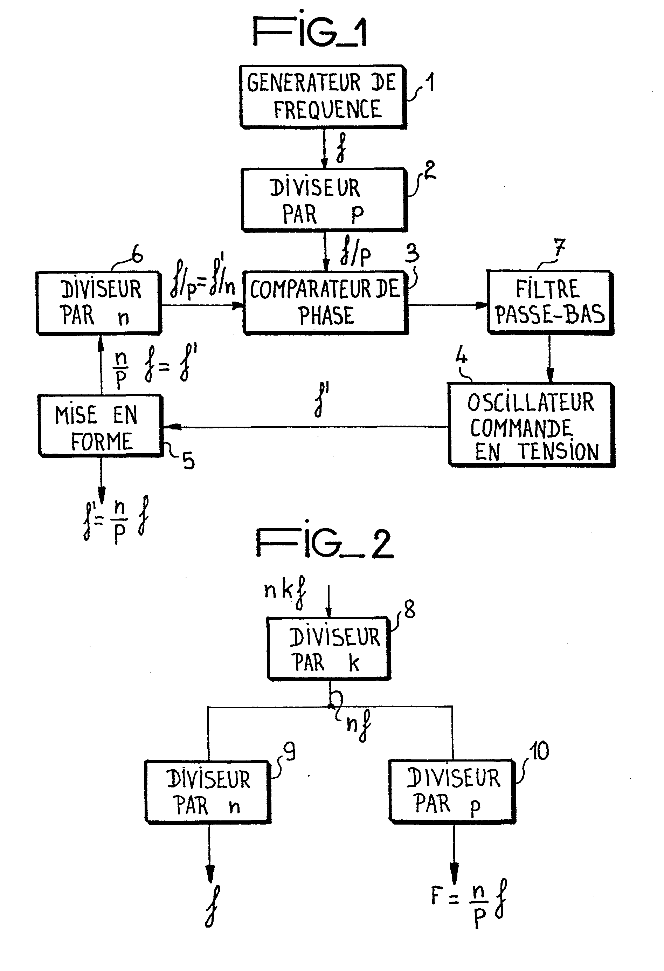

Comme représenté sur la figure 1, la boucle à verrouillage de phase est constituée de manière connue par un générateur 1 de fréquence f dont la sortie est connectée à un diviseur de fréquence 2 par le nombre entier p pour obtenir un signal de fréquence f/p qui est envoyé sur l'une des entrées d'un comparateur de phase 3. D'autre part, elle comporte un oscillateur 4 commandé en tension délivrant un signal de fréquence f' qui, après mise sous forme numérique dans le circuit 5, est envoyé dans un diviseur de fréquence 6 par le nombre entier n. Le signal f'/n en sortie du diviseur 6 est envoyé sur l'autre entrée du comparateur de phase 3 qui donne en sortie un signal contenant notamment f'/n - f/p . Ce signal est envoyé sur un filtre passe-bas 7 de manière à obtenir en sortie uniquement le signal représentatif de l'erreur qui commande l'oscillateur 4 pour modifier, en conséquence, la fréquence f'. Dans ce cas, la boucle étant fermée, l'on a f/p = f'/n d'ou $f' = \frac{n}{p} f$.

Ainsi, on peut obtenir en sortie du circuit de mise en forme un signal d'horloge de fréquence $f' = \frac{n}{p} f$ .

Toutefois, la boucle à verrouillage de phase présente l'inconvénient d'être réalisée à l'aide de circuits de type analogique qui nécessitent des tensions d'alimentation différentes de la tension d'alimentation unique requise pour les circuits numériques.

L'autre solution habituellement employée est l'utilisation de la fréquence PPCM.

Le dispositif permettant cette utilisation est un dispositif de conception simple n'utilisant que des circuits numériques. En effet, comme représenté sur la figure 2, le dispositif est constitué essentiellement de trois diviseurs de fréquence, à savoir un premier diviseur 8 qui, à partir de la fréquence PPCM n k f des fréquences à générer, effectue une première division par le nombre entier k puis deux diviseurs 9, 10 montés en parallèle qui divisent respectivement la fréquence n f obtenue en sortie du diviseur 8 par le nombre entier n pour obtenir la fréquence de référence f et par le nombre entier p pour obtenir la fréquence fractionnaire $\frac{n}{p}$ f. Toutefois, avec ce dispositif il est nécessaire de disposer de la fréquence PPCM des fréquences à générer, ce qui n'est pas toujours possible.

La présente invention a donc pour but de remédier à ces inconvénients en fournissant un nouveau dispositif de génération d'une fréquence fractionnaire d'une fréquence de référence n'utilisant que des circuits de type numérique et générant avec un minimum de composants discrets la fréquence fractionnaire, à partir des signaux de commande existant, en particulier à partir du signal à la fréquence de référence.

En conséquence, la présente invention a pour objet un dispositif de génération d'une fréquence fractionnaire d'une fréquence de référence constitué essentiellement par un générateur dé fréquence de référence délivrant en sortie un signal de référence de fréquence f, un diviseur de fréquence par un nombre entier p délivrant en sortie un signal à la fréquence f/p et un moyen numérique d'extraction de la fréquence harmonique de rang n délivrant un signal à une fréquence multiple de manière à obtenir en sortie dudit dispositif un signal de type numérique de fréquence $\frac{n}{p}$ f, ce moyen numérique étant constitué par un inverseur numérique, une impédance de rebouclage connectée entre la sortie et l'entrée de l'inverseur numérique et une impédance de charge connectée en entrée de l'inverseur numérique, les impédances de rebouclage et de charge étant choisies de manière à ce qu'au moins l'impédance de rebouclage présente un maximum ou l'inpédance de charge présente un minimum à la fréquence $\frac{n}{P}$ f de la fréquence harmonique à extraire.

La structure du dispositif décrite ci-dessus est la structure la plus générale.

Toutefois, si la fréquence de sortie est de la forme n f , c'est à dire si p = 1 , le dispositif décrit ci-dessus ne comporte pas de diviseur.

D'autres caractéristiques et avantages de la présente invention apparaîtront à la lecture de la description de divers modes de réalisation faite ci-après avec référence aux dessins ci-annexés dans lesquels ;

- la figure 1 est un schéma synoptique d'une boucle à verrouillage de phase selon l'art antérieur ;

- la figure 2 est un schéma synoptique d'un dispositif utilisant la fréquence PPCM des fréquences à générer conformément à l'art antérieur ;

- la figure 3 est un schéma synoptique d'un dispositif de génération d'une fréquence fractionnaire d'une fréquence de référence conformément à la présente invention ;

- la figure 4 représente un mode de réalisation du diviseur de fréquence du dispositif de la figure 3 ;

- la figure 5 représente un autre mode de réalisation du diviseur de fréquence du dispositif de la figure 3 ;

- la figure 6 représente un mode de réalisation général du moyen d'extraction de la fréquence harmonique de rang n utilisé dans le dispositif de la figure 3 ;

- les figures 7(a) et 7(b) représentent deux courbes expliquant le fonctionnement du circuit de la figure 6 ;

- la figure 8 représente un mode de réalisation détaillé du moyen d'extraction de la fréquence harmonique de rang n utilisé dans le dispositif de la figure 3 ;

- la figure 9 est un schéma synoptique d'un mode d'utilisation du dispositif de la figure 3 ;

- la figure 10 représente les fréquences en fonction du temps en sortie des différents circuits constituant le mode de réalisation de la figure 9.

Les figures 1 et 2 ont été décrites dans l'introduction.

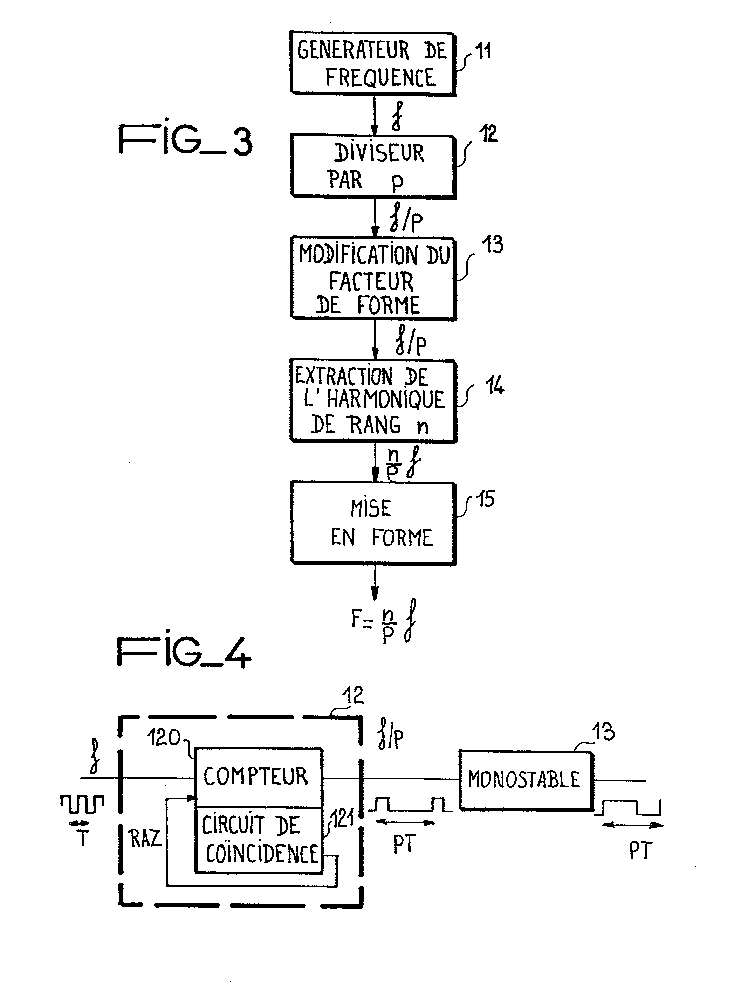

Comme représenté sur le schéma synoptique de la figure 3, le dispositif de génération d'une fréquence fractionnaire d'une fréquence de référence selon l'invention est constitué principalement par un générateur de fréquence 11, un diviseur de fréquence 12 par un nombre entier, éventuellement un circuit 13 de modification du facteur de forme, un circuit 14 d'extraction de la fréquence harmonique de rang n, et un circuit 15 de mise en forme du signal donnant en sortie un signal de type numérique à la fréquence fractionnaire souhaitée.

Le générateur de fréquence 11 est habituellement constitué par l'horloge de référence du système numérique dans lequel est utilisé le dispositif de la présente invention . Ce générateur 11 génère en sortie un signal d'horloge de type numérique de fréquence f. Toutefois le dispositif de la présente invention peut aussi être utilisé pour générer un signal de type numérique à partir d'un signal sinusoïdal et dans ce cas le générateur de fréquence est un générateur de signal sinusoïdal de fréquence f.

Le signal de fréquence f est envoyé dans un diviseur de fréquence 12 par un nombre entier de manière à obtenir en sortie un signal à la fréquence f/p. Différents types de diviseurs de fréquence peuvent être utilisés.

Comme représenté sur la figure 4, le diviseur de fréquence 12 est constitué par un compteur 120 qui effectue une incrémentation d'une unité à chaque cycle d'horloge et sera remis automatiquement à zéro par l'intermédiaire d'un circuit de coïncidence 121 lorsqu'il aura effectué p incrémentations, p étant le rapport de division. A chaque remise à zéro, le compteur délivera en sortie une impulsion à la fréquence f/p. Dans le cas de l'entrée d'un signal sinusoïdal, le compteur sera précédé d'un circuit de mise en forme. D'autre part, afin d'obtenir dans le signal de fréquence f/p un taux important de l'harmonique que l'on cherche à extraire par la suite, il est possible, suivant la valeur du nombre entier p, de modifier le facteur de forme du signal à savoir la durée à l'état 1 par rapport à la durée à l'état zéro du signal de type numérique de fréquence f/p obtenu en sortie du diviseur. Comme représenté sur la figure 4, ce circuit 13 de modification du facteur de forme peut être constitué par une bascule monostable.

Selon un autre mode de réalisation, le circuit diviseur 12 peut être réalisé par un décompteur qui après avoir été chargé à la valeur p effectue à partir de cette valeur une décrémentation d'une unité à chaque cycle d'horloge jusqu'à atteindre la valeur zéro. Lorsque le compteur atteint la valeur zéro, il délivre une impulsion à la fréquence f/p et en même temps un circuit de commande réinitialise le compteur à la valeur p.

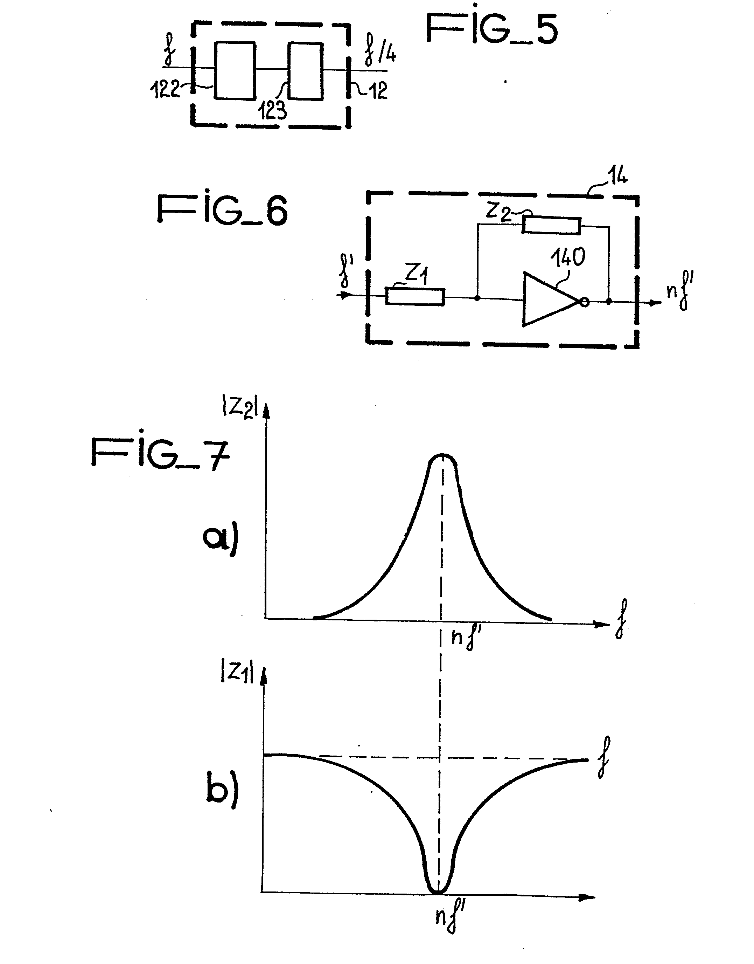

Selon encore un autre mode de réalisation représenté à la figure 5, dans le cas notamment où le nombre entier p est une puissance entière de 2, le diviseur de fréquence 12 peut être réalisé à l'aide de bascules bistables. Ainsi dans le cas d'une division par 4, le diviseur 12 comporte deux bascules bistables 122 et 123 montées en série.

Le signal de type numérique de fréquence f/p obtenu en sortie du diviseur de fréquence 12 ou éventuellement en sortie du circuit 13 de modification du facteur de forme est envoyé sur le circuit 14 d'extraction de la fréquence harmonique de rang n.

Comme représenté sur la figure 6, le circuit 14 est constitué essentiellement par un inverseur de type numérique 140. Entre la sortie et l'entrée de l'inverseur numérique 140 est connectée une impédance de rebouclage $Z_2$ qui permet notamment de positionner le point de fonctionnement de l'inverseur numérique dans la zone de transition. D'autre part, une impédance de charge $Z_1$ est connectée en série entre la sortie du diviseur de fréquence 12 et l'entrée de l'inverseur numérique 140.

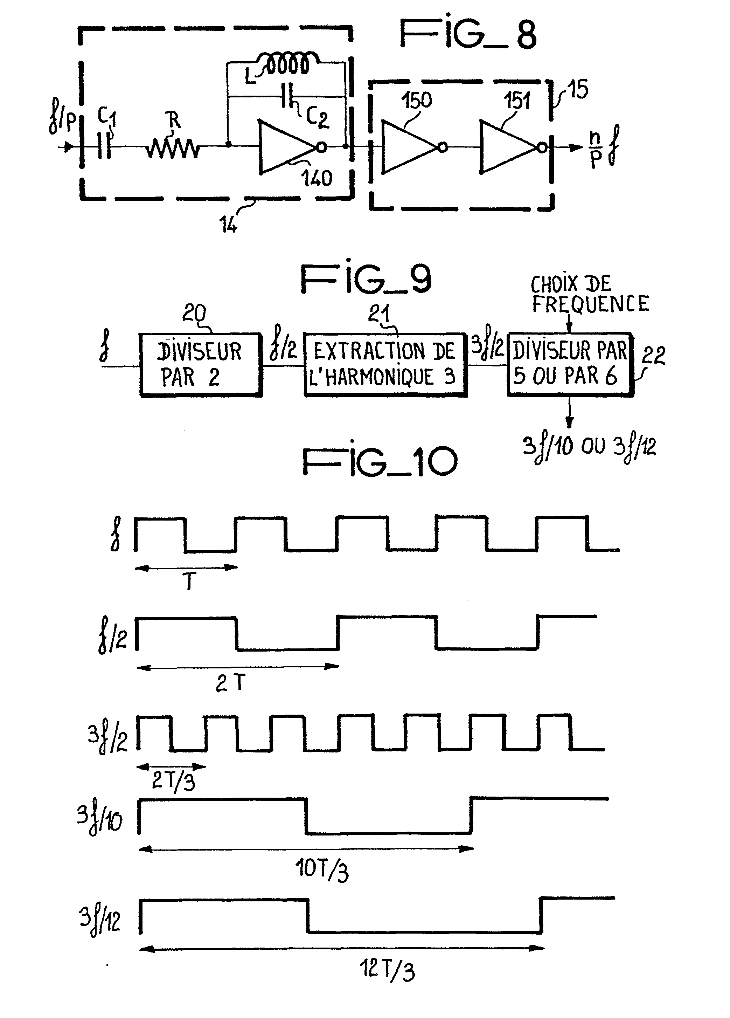

Différents types de circuits peuvent être utilisés pour réaliser l'impédance $Z_2$ et l'impédance $Z_1$. La seule condition à laquelle doivent répondre les deux impédances, est que, l'impédance $Z_2$ présente un maximum pour la fréquence harmonique que l'on cherche à extraire et/ou l'impédance $Z_1$ présente un minimum pour la fréquence harmonique à extraire. Ainsi, comme représenté sur la figure 8, l'impédance $Z_2$ peut être constituée par un circuit résonnant comprenant une self L montée en parallèle sur une capacité $C_2$, les valeurs de la self L et de la capacité $C_2$ étant choisies de telle sorte que la fréquence harmonique de rang n à savoir n f' dans le cas de la figure 6 ou $\frac{n}{p} f$ dans le cas de la figure 8 réponde à l'équation suivante :

$$n f' = \frac{n}{p} f = \frac{1}{2\pi\sqrt{L C_2}} \quad \text{(voir figure 7(a))}$$

Comme représenté sur la figure 8 l'impédance $Z_1$ peut être constituée par une résistance R. Toutefois cette impédance $Z_1$ peut aussi être réalisée à l'aide d'un circuit oscillant série présentant un minimum de fréquence à la fréquence harmonique n f' comme représenté sur la figure 7(b). D'autre part, une capacité $C_1$ est prévue en amont de l'impédance $Z_1$ pour ne transmettre au circuit d'extraction 14 de la fréquence harmonique de rang n, que la composante alternative du signal d'entrée afin de ne pas perturber le fonctionnement de l'inverseur.

En ce qui concerne le fonctionnement du circuit 14, celui ci peut être assimilé ,par analogie avec les circuits linéaires tels que les amplificateurs opérationnels, au fonctionnement d'un filtre..

Le filtrage de la fréquence harmonique de rang n est obtenu dans le mode de réalisation représenté à la figure 8, grâce au circuit résonnant L $C_2$ qui oscille à la fréquence harmonique recherchée comme décrit ci-dessus. Le filtrage de la fréquence harmonique de rang n peut aussi être réalisé par l'impédance Z 1 lorsque celle-ci est constituée d'un circuit oscillant série.

En fonction de différentes caractéristiques telles que la pente de la fonction de transfert de l'inverseur 140 au point de polarisation, le facteur de qualité du circuit oscillant L $C_2$ ou le rapport entre la valeur de l'impédance du circuit L $C_2$ et la valeur de l'impédance Z 1 à savoir de la résistance R à la fréquence de résonnance,le montage de la figure 8 peut être auto-oscillant ou non.

Lorsque le montage est auto-oscillant, l'oscillation ainsi produite est synchronisée par la fréquence harmonique de rang n contenue dans le signal entrée. Lorsque le montage est du type à oscillation amortie l'oscillation à la fréquence harmonique est relancée par la fréquence harmonique.

Toutefois, le signal obtenu en sortie du circuit 14 est un signal de forme sinusoïdale écrêté ou non.

Si le signal en entrée du circuit 14 est fort, il est possible d'obtenir en sortie un signal très écrêté à savoir un signal pseudo numérique. Toutefois dans la majorité des cas, le signal obtenu en sortie du circuit 14 sera envoyé dans un circuit 15 de mise en forme constitué, comme représenté sur la figure 8, par plusieurs inverseurs numériques 150, 151 permettant d'obtenir en sortie un signal de type numérique à la fréquence n f/p. Le point de fonctionnement des inverseurs 150 et 151 est fixé par l'inverseur 140. Le gain de chaque inverseur permet d'obtenir en sortie du dispositif des signaux exactement de type numérique.

Lorsque les valeurs de n et de p sont importantes et qu'il est possible de décomposer le rapport n/p sous la forme suivante : n/p = $n_1 . n_2 . n_3 .... / p_1 . p_2 . p_3 ...$ dans lequel $n_i$ et $p_i$ sont des nombres

entiers relativement petits. Ce dispositif de génération de fréquence fractionnaire d'une fréquence de référence conforme à la présente invention est alors constitué par une suite de cellules montées en série constituées chacune essentiellement par un diviseur de fréquence par un nombre entier $p_i$ et un moyen d'extraction de la fréquence harmonique de rang $n_i$ de telle sorte que chaque cellule soit adaptée à $n_i/p_i$.

On décrira maintenant avec référence aux figures 9 et 10, un mode d'utilisation du dispositif de génération de fréquence fractionnaire d'une fréquence de référence conforme à la présente invention. Comme représenté sur la figure 9, on souhaite obtenir à partir d'une fréquence de référence f une fréquence fractionnaire $\frac{3f}{2}$ cette fréquence fractionnaire étant utilisée ultérieurement pour obtenir deux fréquences fractionnaires différentes, à savoir une fréquence 3f/10 ou une fréquence 3f/12. En conséquence le dispositif conforme à la présente invention est constitué par un diviseur de fréquence par 2, 20 donnant en sortie un signal de fréquence f/2 et par un moyen d'extraction 21 de la fréquence harmonique de rang 3 donnant en sortie un signal numérique de fréquence 3f/2 comme représenté sur la figure 10. Le signal numérique de fréquence 3f/2 est ensuite envoyé dans un diviseur de fréquence programmable 22 pouvant diviser la fréquence par 5 ou par 6 de manière à obtenir la fréquence 3f/10 ou la fréquence 3f/12 selon la valeur 5 ou 6 rentrée dans le diviseur 22. En pratique, ce dispositif à été utilisé pour obtenir des signaux numériques de fréquence 9 MHz ou 7,5 MHz synchrones d'un signal d'horloge à 30 MHz.

Ainsi, il est possible avec le dispositif décrit ci-dessus de générer, uniquement avec des circuits de type numérique, une fréquence fractionnaire d'une fréquence de référence à savoir le plus souvent de la fréquence d'horloge de référence. Les circuits numériques utilisés sont des circuits de type usuel dans la technologie numérique à savoir des circuits TTL, C-MOS ou similaire.

Dans la description ci-dessus, on a fait référence à un diviseur de fréquence par un nombre fixe. Toutefois il est evident. pour l'homme de l'art que l'on peut utiliser si nécessaire un diviseur de fréquence programmable de manière à obtenir en sortie du dispositif un signal numérique de fréquence $\frac{n}{p}$ f lequel p peut être modifié si nécessaire. D'autre part, dans le cas d'une division par un, le diviseur de fréquence est omis dans le dispositif décrit ci-dessus.

De plus, le dispositif de la présente invention peut être utilisé pour générer la fréquence PPCM des différentes fréquences que l'on désire utiliser dans un système numérique.

10

R E V E N D I C A T I O N S

1. Un dispositif de génération d'une fréquence fractionnaire d'une fréquence de référence du type comportant, montés en série

- un générateur (11) de fréquence de référence délivrant en sortie un signal de référence de fréquence f et

- un moyen numérique (14) d'extraction de la fréquence harmonique de rang n, n étant un nombre entier, pour obtenir en sortie du dispositif un signal de type numérique de fréquence n f, caractérisé en ce que le moyen numérique (14) d'extraction de la fréquence harmonique de rang n est constitué par un inverseur numérique (14), une impédance de rebouclage (Z 2) connectée entre la sortie et l'entrée de l'inverseur numérique et une impédance de charge (Z 1) connectée en entrée de l'inverseur numérique, les impédances de rebouclage et de charge étant choisies de manière à ce qu'au moins l'impédance de rebouclage (Z 2) présente un maximum ou l'impédance de charge (Z 1) présente un minimum à la fréquence n f de la fréquence harmonique à extraire.

2. Un dispositif selon la revendication 1 caractérisé en ce que l'impédance de rebouclage (Z 2) est constituée par un circuit résonnant (L C$_2$) dont la fréquence de résonnance correspond à la fréquence harmonique à extraire.

3. Un dispositif selon l'une quelconque des revendications 1 et 2 caractérisé en ce que l'impédance de charge (Z 1) est constituée par une résistance (R).

4. Un dispositif selon l'une quelconque des revendications 1 et 2 caractérisé en ce que l'impédance de charge (Z 1) est constituée par un circuit oscillant série dont la fréquence d'oscillation correspond à la fréquence harmonique à extraire.

5. Un dispositif selon l'une quelconque des revendications 1 à 4 caractérisé en ce qu'il comporte un moyen (15) de mise en forme numérique monté en sortie du moyen numérique (14) d'extraction de la fréquence harmonique de rang n.

6. Un dispositif selon la revendication 5 caractérisé en ce que le moyen (15) de mise en forme numérique est constitué par au moins un inverseur numérique (150, 151).

7. Un dispositif selon l'une quelconque des revendications 1 à 6 caractérisé en ce qu'il comporte de plus un diviseur de fréquence (12) par un nombre entier p pour obtenir en sortie du dispositif un signal numérique de fréquence $\frac{n}{p}$ f.

8. Un dispositif selon la revendication 7 caractérisé en ce que le diviseur de fréquence (12) est monté en série entre le générateur (11) de fréquence de référence et le moyen numérique (14) d'extraction de la fréquence harmonique.

9. Un dispositif selon la revendication 8 caractérisé en ce qu'il comporte entre le diviseur de fréquence (12) et le moyen numérique (14) d'extraction de la fréquence harmonique, un moyen (13) de modification du facteur de forme du signal de type numérique obtenu en sortie du diviseur.

10. Un dispositif selon l'une quelconque des revendications 7 à 9 caractérisé en ce que le diviseur de fréquence (11) est un diviseur programmable permettant de modifier la valeur du nombre entier p.

11. Un dispositif selon l'une quelconque des revendications 1 à 9 caractérisé en ce que le signal de référence de fréquence f est un signal d'horloge de type numérique.

12. Un dispositif de génération d'une fréquence fractionnaire d'une fréquence de référence caractérisé en ce qu'il est constitué par au moins deux dispositifs élémentaires de génération d'une fréquence fractionnaire selon l'une quelconque des revendications 1 à 10, chaque dispositif permettant d'obtenir en sortie une fréquence fractionnaire $\frac{n_i}{p_i}$ des fréquences entrée.

0142440

1/4

## FIG_1

**GENERATEUR DE FREQUENCE** — 1

$f$

**DIVISEUR PAR P** — 2

$f/P$

**DIVISEUR PAR n** — 6 $\quad f/P = f'/n \quad$ **COMPARATEUR DE PHASE** — 3 $\quad$ **FILTRE PASSE-BAS** — 7

$\frac{n}{P} f = f'$

**MISE EN FORME** — 5 $\qquad f' \qquad$ **OSCILLATEUR COMMANDE EN TENSION** — 4

$f' = \frac{n}{P} f$

## FIG_2

$n k f$

**DIVISEUR PAR k** — 8

$n f$

**DIVISEUR PAR n** — 9 $\qquad$ **DIVISEUR PAR p** — 10

$f \qquad F = \frac{n}{P} f$

## FIG_3

GENERATEUR DE FREQUENCE — 11

$\downarrow f$

DIVISEUR PAR p — 12

$\downarrow f/p$

MODIFICATION DU FACTEUR DE FORME — 13

$\downarrow f/p$

EXTRACTION DE L' HARMONIQUE DE RANG n — 14

$\downarrow \frac{n}{p} f$

MISE EN FORME — 15

$\downarrow$

$F = \frac{n}{p} f$

## FIG_4

$f$ — 12

COMPTEUR — 120

$f/p$

CIRCUIT DE COÏNCIDENCE — 121

RAZ

T

PT

MONOSTABLE — 13

PT

0142440

3/4

FIG_5

FIG_6

FIG_7

a)

b)

FiG_8

FiG_9

FiG_10